# EUROPEAN PATENT APPLICATION

(11) **EP 4 726 081 A1**
(43) Date of publication of application: **15.04.2026**
(21) Application number: 24822689.6
(22) Date of filing: 11.06.2024
(51) Int. Cl.: C30B 25/14, C30B 25/08, H01L 21/67

(54) **REACTION DEVICE, SEMICONDUCTOR COATING DEVICE, AND COATING METHOD THEREOF**

(30) Priority: 12.06.2023 CN 202310689192
(71) Applicant: Jiangsu Leadmicro Nano-Technology Co., Ltd., Wuxi, Jiangsu 214028 (CN)
(72) Inventor: ZHOU, Yunfu, Wuxi, Jiangsu 214028 (CN); LI, Weimin, Wuxi, Jiangsu 214028 (CN); XU, Yunxin, Wuxi, Jiangsu 214028 (CN); GUO, Yunfei, Wuxi, Jiangsu 214028 (CN); XU, Suochang, Wuxi, Jiangsu 214028 (CN)
(74) Representative: De Arpe Tejero, Manuel
(86) International application number: PCT/CN2024/098489
(87) International publication number: WO 2024/255739

(57) **Abstract**

A reaction device (10) includes a reaction housing (11) defining a reaction chamber (111), a first cover plate (12), an intake assembly (13) that is disposed on the first cover plate (12) and communicated with the reaction chamber (111), and a flow equalizing plate (14) disposed between the first cover plate (12) and the reaction housing (11). The reaction housing (11) includes a first end (112) and a second end (113). The first cover plate (12) is disposed on the first end (112). An arrangement direction of the first cover plate (12) and the flow equalizing plate (14) is perpendicular to a vertical axis of a reactant, a wall surface of the flow equalizing plate (14) facing the first cover plate (12) is configured as a protrusion, and a wall surface of the first cover plate (12) facing the flow equalizing plate (14) is configured as a recess.

## Description

The present application claims priority to Chinese Patent Application No. 202310689192.0, entitled "REACTION DEVICE, SEMICONDUCTOR COATING DEVICE, AND COATING METHOD THEREOF", filed on June 12, 2023, which is herein incorporated by reference in its entirety.

### TECHNICAL FIELD

The present disclosure relates to the technical field of semiconductor, and in particular to a reaction device, a semiconductor coating device, and a coating method thereof.

### BACKGROUND

In an epitaxial process chamber in related art, a reaction gas is transported into a semiconductor process chamber, and a process gas experiences chemical reactions through heating or other methods. However, diffusion of the process gas above a reactant is usually not uniform enough, resulting in poor thickness uniformity of a film on the reactant, which can affect reaction results.

### SUMMARY OF THE DISCLOSURE

The present disclosure provides a reaction device, a semiconductor coating device, and a coating method thereof, so as to solve a technical problem of uneven diffusion of a process gas above a reactant.

In order to solve the above technical problem, a technical solution adopted in the present disclosure is to provide a reaction device including a reaction housing, a first cover plate, an intake assembly, and a flow equalizing plate. The reaction housing defines a reaction chamber, the reaction chamber is configured to accommodate a reactant, and the reaction housing includes a first end and a second end opposite to each other. The first cover plate is disposed on the first end. The intake assembly is disposed on the first cover plate and communicated with the reaction chamber. The flow equalizing plate is disposed between the first cover plate and the reaction housing. An arrangement direction of the first cover plate and the flow equalizing plate is perpendicular to a vertical axis of the reactant, a wall surface of the flow equalizing plate facing the first cover plate is configured as a protrusion, and a wall surface of the first cover plate facing the flow equalizing plate is configured as a recess.

In some embodiments, the wall surface of the flow equalizing plate facing the first cover plate is an arc-shaped surface; and in a first direction, a distance between the flow equalizing plate and the first cover plate gradually increases from a middle to both ends.

In some embodiments, the wall surface of the first cover plate facing the flow equalizing plate is the arc-shaped surface; in a second direction, the distance between the first cover plate and the flow equalizing plate gradually decreases from the middle to the both ends; and the second direction intersects with the first direction.

In some embodiments, a central angle of the arc-shaped surface is greater than 0 degrees and less than or equal to 15 degrees.

In some embodiments, at least two intake ports that are spaced apart from each other are defined on the first cover plate, and the intake assembly includes at least two intake end covers and at least two sets of intake pipes. Each intake end cover is disposed to cover a corresponding intake port. Each set of intake pipes includes a connection pipe and a ventilation pipe, the connection pipe is communicated with each intake end cover, and the ventilation pipe is communicated with the connection pipe.

In some embodiments, two intake ports are defined on the first cover plate, and the two intake ports are spaced apart from each other; two intake end covers are disposed, two sets of intake pipes are disposed, and each set of intake pipes includes one connection pipe and one ventilation pipe; and the connection pipe is communicated with the two intake end covers, and the ventilation pipe is communicated with a middle of the connection pipe.

In some embodiments, in a spacing direction of two intake ports, one of the two intake ports is defined at a one-third point of the first cover plate, and the other of the two intake ports is defined at a two-third point of the first cover plate.

In some embodiments, the intake assembly further includes a flow guide block, the flow guide block is disposed on a side of each intake end cover facing the corresponding intake port, and connection ends of the connection pipe that are communicated with each intake end cover are disposed around periphery of the flow guide block at intervals.

In some embodiments, the reaction device further includes a partition plate, the partition plate is disposed between the flow equalizing plate and the first cover plate, and a plurality of intake holes are defined in an array on the partition plate.

In some embodiments, the partition plate is provided with a partition sub-plate corresponding to each intake port, and a plurality of flow guide holes are defined in an array on the partition sub-plate.

In some embodiments, the reaction device further includes an exhaust assembly, the exhaust assembly is disposed on the reaction housing, and the exhaust assembly includes a second cover plate and an exhaust tube. The second cover plate is disposed on the second end of the reaction housing and defining an exhaust port. The exhaust tube is disposed on the second cover plate and communicated with the exhaust port.

In some embodiments, the second end of the reaction housing includes a first side and a second side opposite to each other, as well as a third side and a fourth side opposite to each other. The second cover plate includes two semi-circular plates and an arc-shaped plate. Each of the first side and the second side is provided with one semi-circular plate, and the two semi-circular plates are inclined towards each other. The arc-shaped plate is connected to the third side, the fourth side, and outer edges of the two semi-circular plates. The exhaust port is defined on the arc-shaped plate, and the arc-shaped plate and the two semi-circular plates enclose to form an exhaust chamber with a gradually decreasing inner diameter.

In some embodiments, the reaction device further includes a temperature sensor, and the temperature sensor is disposed on a top of the reaction housing and configured to measure a temperature inside the reaction chamber.

In some embodiments, the reaction device further includes a gas sub-pipe and an annular groove. The gas sub-pipe is disposed on a side wall of the flow equalizing plate and configured for introducing an inert gas. The annular groove is defined on periphery of the first end of the reaction housing and communicated with the gas sub-pipe to form a gas seal.

In some embodiments, the reaction device further includes fixing studs, each of two opposite sides of the reaction housing is provided with one fixing stud, and a height of each fixing stud is greater than or equal to half of a height of the reaction housing.

In order to solve the above technical problem, another technical solution adopted in the present disclosure is to provide a semiconductor coating device including the reaction device of any one of above embodiments.

In order to solve the above technical problem, yet another technical solution adopted in the present disclosure is to provide a coating method. The coating method adopts the reaction device of any one of above embodiments or the above semiconductor coating device. The coating method includes: disposing the reactant in the reaction housing; and supplying a reaction source through the intake assembly, wherein the reaction source enters the reaction housing after passing through the first cover plate and the flow equalizing plate in sequence.

In the above technical solution, the first cover plate, the intake assembly, and the flow equalizing plate are disposed on the reaction housing. The wall surface of the flow equalizing plate facing the first cover plate is configured as the protrusion, and the wall surface of the first cover plate facing the flow equalizing plate is configured as the recess. This structure enables diffusion of the reaction source to be more uniform during the reaction source entering the reaction chamber for reaction, resulting in a more uniform distribution of the reaction source on the reactant and improving thickness uniformity of a film on the reactant. Disposing an independent reaction chamber can also effectively solve the problem of inconsistent gas flow resistance on the reactant, further improving the thickness uniformity of the film.

### BRIEF DESCRIPTION OF THE DRAWINGS

In order to more clearly describe the technical solutions in some embodiments of the present disclosure, hereinafter, accompanying drawings that are used in the description of some embodiments will be briefly described. Obviously, the accompanying drawings in the description below merely show some embodiments of the present disclosure. For those of ordinary skill in the art, other accompanying drawings may be obtained based on these accompanying drawings without any creative efforts.
FIG. 1 is an overall structural schematic view of an embodiment of a reaction device of the present disclosure.
FIG. 2 is an exploded structural schematic view of an embodiment of the reaction device of the present disclosure.
FIG. 3 is a cross-sectional structural schematic view illustrating a flow equalizing plate facing a first cover plate in an embodiment of the reaction device of the present disclosure.
FIG. 4 is a cross-sectional structural schematic view illustrating the first cover plate facing the flow equalizing plate in an embodiment of the reaction device of the present disclosure.
FIG. 5 is a structural schematic view illustrating an intake assembly disposed on the first cover plate in an embodiment of the reaction device of the present disclosure.
FIG. 6 is another overall structural schematic view of an embodiment of the reaction device of the present disclosure.
FIG. 7 is a flowchart of an embodiment of a coating method of the present disclosure.

### DETAILED DESCRIPTION

The technical solutions in some embodiments of the present disclosure may be clearly and completely described in conjunction with accompanying drawings in some embodiments of the present disclosure. Obviously, the described embodiments are only a part of the embodiments of the present disclosure, and not all embodiments. Based on the embodiments in the present disclosure, all other embodiments obtained by those of ordinary skill in the art without creative effort are within the scope of the present disclosure.

It should be noted that when there are descriptions of "first", "second", etc. in the embodiments of the present disclosure, the descriptions of "first", "second", etc. are only configured to describe and cannot be understood as indicating or implying relative importance or implicitly indicating the quantity of technical features indicated. Therefore, a feature that is defined as "first" or "second" may explicitly or implicitly include at least one of these features. In addition, the technical solutions between various embodiments can be combined with each other, but the combination must be able to be implemented by those of ordinary skill in the art. When the combination of the technical solutions is contradictory or cannot be implemented, it should be considered that this combination of the technical solutions does not exist and is not within protection scope required by the present disclosure.

In order to better understand the present disclosure, more detailed descriptions of a reaction device, a semiconductor coating device, and a coating method thereof provided in the present disclosure are provided below in conjunction with the accompanying drawings and specific embodiments.

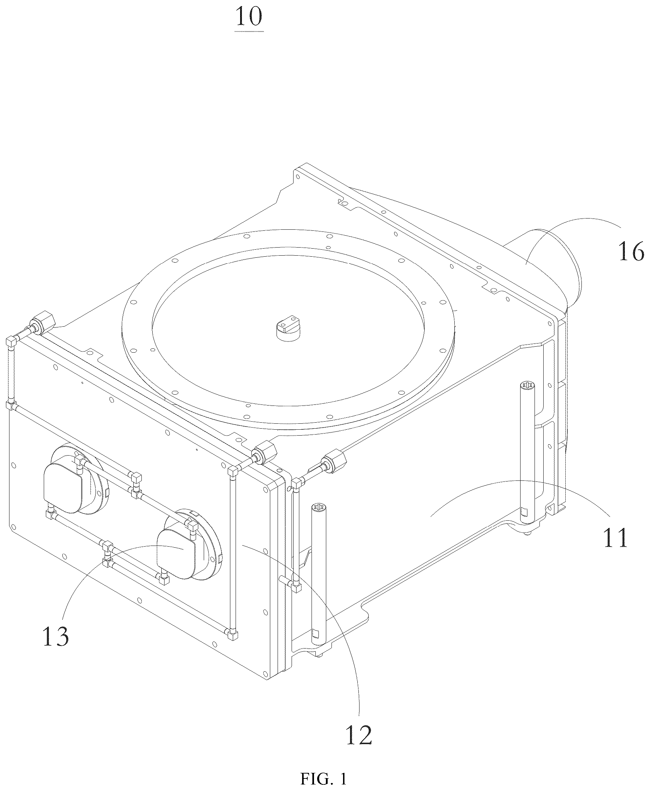

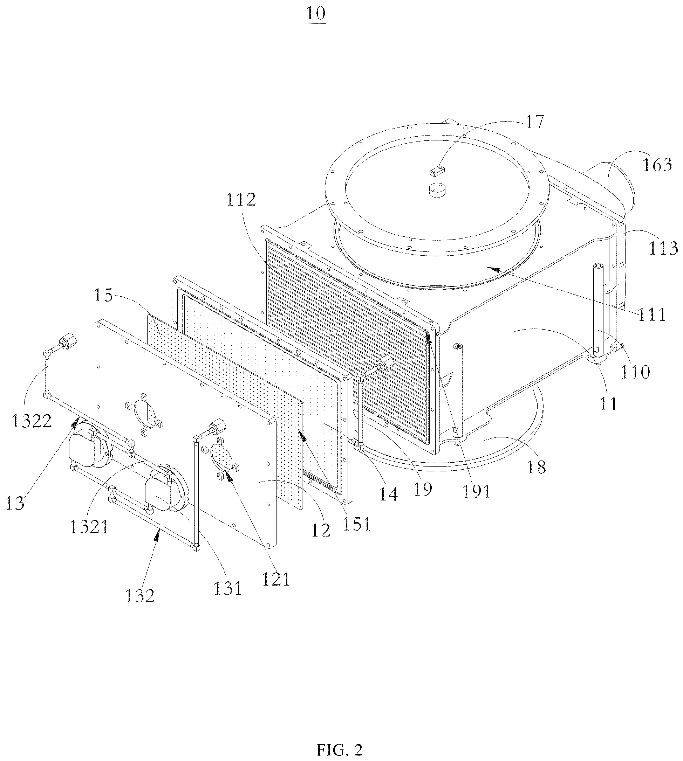

As illustrated in FIGS. 1 and 2, FIG. 1 is an overall structural schematic view of an embodiment of a reaction device of the present disclosure, and FIG. 2 is an exploded structural schematic view of an embodiment of the reaction device of the present disclosure.

An embodiment of the present disclosure provides a reaction device 10. The reaction device 10 includes a reaction housing 11, a first cover plate 12, an intake assembly 13, and a flow equalizing plate 14. A reaction chamber 111 is defined inside the reaction housing 11 and configured for accommodating a reactant. The reaction housing 11 includes a first end 112 and a second end 113 that are opposite to each other. The first cover plate 12 is disposed on and covers the first end 112. The intake assembly 13 is disposed on the first cover plate 12. The intake assembly 13 is communicated with the reaction chamber 111. The flow equalizing plate 14 is disposed between the first cover plate 12 and the reaction housing 11. Moreover, an arrangement direction of the first cover plate 12 and the flow equalizing plate 14 is perpendicular to a vertical axis of the reactant. A wall surface of the flow equalizing plate 14 facing the first cover plate 12 is configured as a protrusion, while a wall surface of the first cover plate 12 facing the flow equalizing plate 14 is configured as a recess.

From the above structure, it can be seen that the reaction housing 11 can provide an independent reaction chamber 111 for the reactant. Due to good consistency of a volume of the reaction chamber 111 and good consistency of density of air inside the reaction chamber 111, it can better solve the problem of inconsistent gas flow resistance on the reactant. In this case, the consistency of the gas flow resistance on the reactant is good. After a reaction source reacts in the reaction chamber 111, a thickness of a film on the reactant can also be more uniform. Moreover, the arrangement direction of the first cover plate 12 and the flow equalizing plate 14 is perpendicular to the vertical axis of the reactant, and concentration of the reaction source at a position of the intake assembly 13 is relatively high. Therefore, by disposing the wall surface of the flow equalizing plate 14 facing the first cover plate 12 as the protrusion and disposing the wall surface of the first cover plate 12 facing the flow equalizing plate 14 as the recess, a diffusion path of the reaction source at a position close to the intake assembly 13 is longer. This can effectively adjust overall concentration of the reaction source in the reaction chamber 111, so that the reaction source can distribute more uniformly as it diffuses into the reaction chamber 111. In this case, concentration distribution of the reaction source in the reaction chamber 111 is more uniform. Therefore, during the reaction of the reactant in the reaction chamber 111, the reactant is in more uniform contact with the reaction source, thereby improving thickness uniformity of a film on the reactant.

In some embodiments, only the wall surface of the flow equalizing plate 14 facing the first cover plate 12 is configured as the protrusion. In this case, the reaction source enters the first cover plate 12 and the flow equalizing plate 14 from the intake assembly 13 in sequence. After entering the flow equalizing plate 14, the reaction source can diffuse outward, so that the reaction source diffuses more uniformly during entering the reaction chamber 111. In some embodiments, only the wall surface of the first cover plate 12 facing the flow equalizing plate 14 is configured as the recess. In this case, the reaction source can diffuse outward during the reaction source passing through the first cover plate 12 from the intake assembly 13, so that the reaction source diffuses more uniformly during entering the reaction chamber 111. In some embodiments, the wall surface of the flow equalizing plate 14 facing the first cover plate 12 is configured as the protrusion, and at the same time, the wall surface of the first cover plate 12 facing the flow equalizing plate 14 is configured as the recess. In this case, in a case where the reaction source enters the first cover plate 12 and the uniform plate 14 from the intake assembly 13 in sequence, the reaction source is able to diffuse to surrounding areas during the reaction source passing through the first cover plate 12 and the uniform plate 14 respectively. Therefore, the distribution of the reaction source in entire reaction chamber 111 is more uniform, and the concentration distribution of the reaction source in the reaction chamber 111 is more uniform, which is not limited here.

In some embodiments, a grid is disposed on the first end 112 of the reaction housing 11. The reaction source sequentially flows through the first cover plate 12 and the flow equalizing plate 14 from the intake assembly 13, and then enters the reaction chamber 111 from the first end 112. The grid is disposed on the first end 112 of the reaction housing 11, which can allow the reaction source to flow more uniformly into the reaction chamber 111 and diffuse uniformly into the reaction chamber 111. The more uniform the diffusion of the reaction source in the reaction chamber 111, and the more uniform the concentration distribution of the reaction source in the reaction chamber 111. In this case, the reactant is in more uniform contact with the reaction source, thereby improving the thickness uniformity of the film on the reactant.

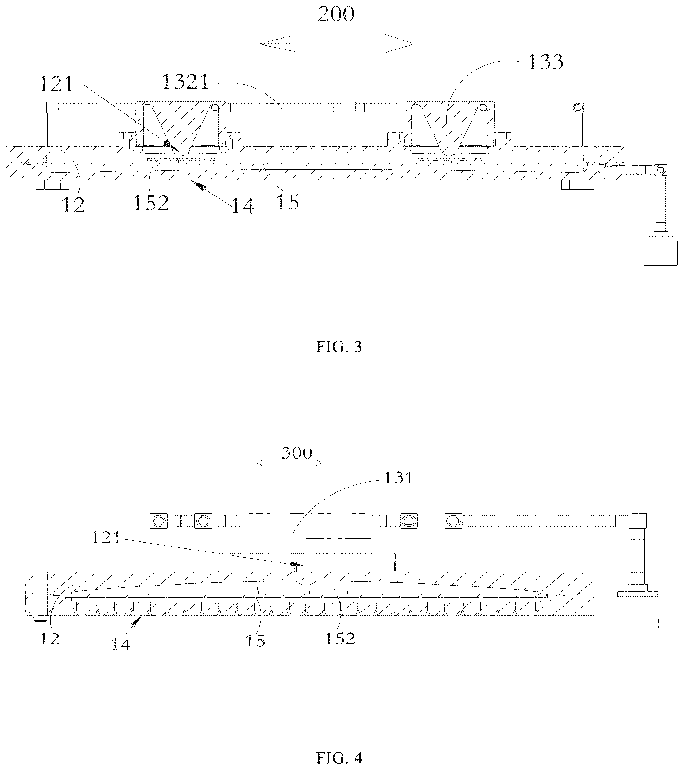

As illustrated in FIGS. 3 to 4, FIG. 3 is a cross-sectional structural schematic view illustrating a flow equalizing plate facing a first cover plate in an embodiment of the reaction device of the present disclosure, and FIG. 4 is a cross-sectional structural schematic view illustrating the first cover plate facing the flow equalizing plate in an embodiment of the reaction device of the present disclosure.

In some embodiments of the present disclosure, the flow equalizing plate 14 has an arc-shaped surface facing the first cover plate 12. In a first direction 200, a distance between the flow equalizing plate 14 and the first cover plate 12 gradually increases from a middle to both ends. In this case, the wall surface of the flow equalizing plate 14 facing the first cover plate 12 is configured as the protrusion, and the reaction source enters the first cover plate 12 and the flow equalizing plate 14 in sequence from the intake assembly 13. During the reaction source passing through the flow equalizing plate 14, the reaction source can uniformly diffuse along the first direction 200 to both sides. A distance between the reaction source in the reaction chamber 111 and the reaction housing 11 can be kept consistent at positions close to and away from the intake assembly 13, thereby ensuring that the reaction source can diffuse more uniformly into the reaction chamber 111 along the first direction 200. In this case, the concentration distribution of the reaction source in the reaction chamber 111 is also more uniform. Therefore, the reactant is in more uniform contact with the reaction source, thereby improving the thickness uniformity of the film on the reactant.

In some embodiments, the first cover plate 12 has an arc-shaped surface facing the flow equalizing plate 14. In a second direction 300, the distance between the first cover plate 12 and the flow equalizing plate 14 gradually decreases from the middle to both ends. The second direction 300 intersects with the first direction 200. In this case, the wall surface of the first cover plate 12 facing the flow equalizing plate 14 is configured as the recess. After the reaction source enters the first cover plate 12 from the intake assembly 13, the reaction source diffuses uniformly along the second direction 300 to both sides. The distance between the reaction source in the reaction chamber 111 and the reaction housing 11 can be kept consistent at positions close to and away from the intake assembly 13, thereby ensuring that the reaction source can diffuse more uniformly into the reaction chamber 111 along the second direction 300. In this case, the concentration distribution of the reaction source in the reaction chamber 111 is also more uniform. Therefore, the reactant is in more uniform contact with the reaction source, thereby improving the thickness uniformity of the film on the reactant.

In some embodiments, the first direction 200 and the second direction 300 may be perpendicular to each other. In a case where the reaction device 10 is in normal use, the first direction 200 is a horizontal direction, and the second direction 300 is a vertical direction. In some embodiments, the first direction 200 may be the vertical direction, and the second direction 300 may be the horizontal direction, which is not limited here. In some embodiments, the first direction 200 may intersect with the second direction 300, but not be perpendicular to the second direction 300. In this case, during the reaction source entering the first cover plate 12 and the flow equalizing plate 14 from the intake assembly 13, the reaction source can diffuse outward along the first direction 200 and the second direction 300, so that the concentration distribution of the reaction source in the reaction chamber 111 is more uniform. Therefore, the reactant is in more uniform contact with the reaction source, thereby improving the thickness uniformity of the film on the reactant, which is not repeated here.

In some embodiments, a central angle of the arc-shaped surface is greater than 0 degrees and less than or equal to 15 degrees. In a case where the central angle of the arc-shaped surface is too large, the reaction source at the position close to the intake assembly 13 has to travel a longer distance to enter the reaction cavity 111. Therefore, after the reaction source enters the reaction chamber 111, the concentration of the reaction source at the position close to the intake assembly 13 can be lower than that of the reaction source at other positions. This can affect overall concentration of the reaction source in the reaction chamber 111 and further affect the thickness uniformity of the film on the reactant. In a case where the central angle of the arc-shaped surface is 0 degrees, the arc-shaped surface is a planar surface and cannot assist in the diffusion of the reaction source, let alone achieve a more uniform diffusion of the reaction source. Therefore, in a case where the central angle of the arc-shaped surface is greater than 0 degrees and less than or equal to 15 degrees, the reaction source can diffuse more uniformly into the reaction chamber 111 for the reaction. Therefore, the concentration distribution of the reaction source in the reaction chamber 111 is more uniform, thereby better ensuring the thickness uniformity of the film on the reactant in the reaction chamber 111.

In some embodiments, the central angle may be 2 degrees, 5 degrees, or 13 degrees, which is not limited here.

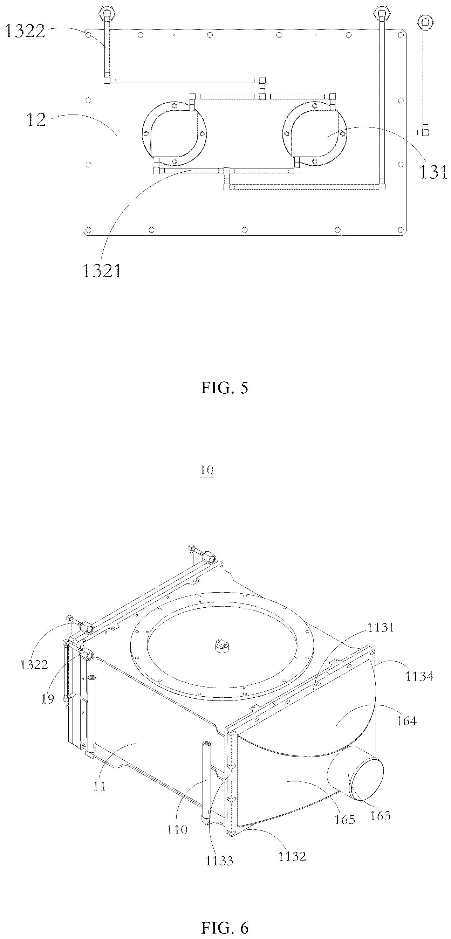

As illustrated in FIG. 2 and FIG. 5, FIG. 5 is a structural schematic view illustrating an intake assembly disposed on the first cover plate in an embodiment of the reaction device of the present disclosure.

In some embodiments, at least two intake ports 121 that are spaced apart from each other are defined on the first cover plate 12. The intake assembly 13 includes an intake end cover 131 and an intake pipe 132. There are at least two corresponding intake end covers 131, and the intake end cover 131 is disposed on and cover the intake port 121. There are at least two sets of intake pipes 132, each set of intake pipes 132 includes a connection pipe 1321 and a ventilation pipe 1322. The connection pipe 1321 is communicated with each intake end cover 131, and the ventilation pipe 1322 is communicated with the connection pipe 1321. By disposing the intake end cover 131 and the intake pipe 132, the reaction source can enter the connection pipe 1321 from the ventilation pipe 1322, so that the reaction source can enter the intake end cover 131 and then enter the intake port 121 from the intake end cover 131.

One set of intake pipes 132 is configured to guide or introduce one reaction source into the reaction chamber 111. Specifically, one reaction source enters the connection pipe 1321 through the ventilation pipe 1322 of the corresponding set of intake pipes 132. The connection pipe 1321 is communicated with each intake end cover 131. Therefore, the reaction source is dispersed into each intake port 121 through the connection pipe 1321 and enters the reaction chamber 111 from the intake port 121, thereby performing the reaction. During the reaction source entering the connection pipe 1321 through the ventilation pipe 1322, the reaction source can be divided into two, three, or four at the connection with the connection pipe 1321, depending on the number of the intake ports 121 communicated with the connection pipe 1321.

In some embodiments, the number of the intake ports 121 may be two, four, or five, which is not limited here. Similarly, the number of the intake pipes 132 may be two, four, or five, depending on the number of the reaction sources, which is not limited here.

In some embodiments of the present disclosure, two intake ports 121 are defined on the first cover plate 12, and the two intake ports 121 are spaced apart from each other. Two intake end cover 131 are correspondingly disposed. There are two sets of intake pipes 132, each set of intake pipes 132 includes one connection pipe 1321 and one ventilation pipe 1322. The connection pipe 1321 is communicated with two intake end covers 131, and the ventilation pipe 1322 is communicated with a middle of the connection pipe 1321. In this case, the reaction source is divided into two parts from the middle of the connection pipe 1321, and then respectively flows into the two intake end covers 131 from the connection pipe 1321. The reaction source enters the intake ports 121 from the two intake end covers 131 and then enters the reaction chamber 111. Therefore, the reaction source can be uniformly distributed and flow to the two intake ports 121. After entering the reaction chamber 111 through the intake ports 121, the reaction source diffuses more uniformly, so that the concentration distribution of the reaction source in the reaction chamber 111 is more uniform. Therefore, the reactant is in more uniform contact with the reaction source, thereby improving the thickness uniformity of the film on the reactant.

In some embodiments, two intake ports 121 are defined on the first cover plate 12. In a spacing direction of the two intake ports 121, one of the two intake ports 121 may be defined at a one-third point of the first cover plate 12, and the other of the two intake ports 121 may be defined at a two-third point of the first cover plate 12. In this case, the intake ports 121 are uniformly distributed on the first cover plate 12, and the reaction source can flow into the reaction chamber 111 more uniformly through the intake ports 121. Therefore, after the reaction occurs in the reaction chamber 111, the thickness of the film on the reactant is also more uniform.

As illustrated in FIGS. 2 and 3, the intake assembly 13 further includes a flow guide block 133. The flow guide block 133 is disposed on a side of the intake end cover 131 facing the intake port 121. Connection ends of the connection pipe 1321 that are communicated with the intake end cover 131 are disposed around periphery of the flow guide block 133 at intervals. On one hand, disposing the flow guide block 133 can provide a certain buffering effect on entry of the reaction source into the intake port 121, so as to avoid uneven distribution of the reaction source due to excessive flow rate. The uneven distribution of the reaction source can affect the overall reaction concentration in the reaction chamber 111. On the other hand, disposing the flow guide block 133 can also play a certain auxiliary role in the diffusion of the reaction source, so that the concentration of the reaction source is more uniform during the diffusion of the reaction source into the reaction chamber 111 through the intake port 121. Therefore, disposing the flow guide block 133 can further improve the thickness uniformity of the film on the reactant.

In some embodiments, the flow guide block 133 may be tapered, cylindrical, or other shapes, which is not limited here.

As illustrated in FIGS. 2 to 4, in some embodiments of the present disclosure, the reaction device 10 further includes a partition plate 15. The partition plate 15 is disposed between the flow equalizing plate 14 and the first cover plate 12, and multiple intake holes 151 are defined in an array on the partition plate 15. Specifically, the reaction source enters the first cover plate 12 from the intake port 121, flows into the flow equalizing plate 14 through multiple intake holes 151 of the partition plate 15, and enters the reaction chamber 111 through the flow equalizing plate 14. Therefore, on one hand, disposing the partition plate 15 can have a certain diffusion effect on the reaction source. On the other hand, multiple intake holes 151 are defined in an array on the partition plate 15, which can allow the diffusion of the reaction source to be more uniform during the reaction source flowing or passing through the partition plate 15.

In order to guide the reaction source at the intake port 121, in some embodiments of the present disclosure, the partition plate 15 is provided with a partition sub-plate 152 corresponding to the intake port 121. Multiple flow guide holes (not shown in the figures) are defined in an array on the partition sub-plate 152. Specifically, during the reaction source flowing into the reaction chamber 111 from the intake port 121, the reaction source is buffered by the flow guide block 133 and then flows into an intake end of the partition sub-plate 152 from an outlet end of the flow guide block 133. Disposing the partition sub-plate 152 can enable the reaction source buffered at the flow guide block 133 to diffuse evenly again, ensuring the uniformity of the concentration of the reaction source in the entire reaction chamber 111. Multiple flow guide holes are defined on the partition plate 152, which can effectively assist in the diffusion of the reaction source, so that the diffusion of the reaction source into the reaction chamber 111 is more uniform, and thus the concentration distribution of the reaction source in the reaction chamber 111 is more uniform. In this case, the reactant is in more uniform contact with the reaction source, thereby improving the thickness uniformity of the film on the reactant.

As illustrated in FIG. 6, FIG. 6 is another overall structural schematic view of an embodiment of the reaction device of the present disclosure. In some embodiments of the present disclosure, the reaction device 10 further includes an exhaust assembly 16. The exhaust assembly 16 is disposed on the reaction housing 11, and the exhaust assembly 16 includes a second cover plate (not shown in the figures) and an exhaust tube 163. The second cover plate is disposed on and covers the second end 113 of the reaction housing 11, and the second cover plate defines an exhaust port (not shown in the figures). The exhaust tube 163 is disposed on the second cover plate, and the exhaust tube 163 is communicated with the exhaust port. In this case, the reacted gas in the reaction chamber 111 can be sequentially discharged through the exhaust port and the exhaust tube 163, there can be no residual gas in the reaction chamber 111, and the thickness of the film on the reactant in the reaction chamber 111 cannot be affected.

In order to improve the efficiency of gas discharge after the reaction in the reaction chamber 111, in some embodiments of the present disclosure, at the second end 113, the reaction housing 11 includes a first side 1131 and a second side 1132 opposite to each other, as well as a third side 1133 and a fourth side 1134 opposite to each other. The second cover plate includes two semi-circular plates 164 and an arc-shaped plate 165. The two semi-circular plates 164 are respectively disposed on the first side 1131 and the second side 1132, and the two semi-circular plates 164 are inclined towards each other. The arc-shaped plate 165 is connected to the third side 1133 and the fourth side 1134, and the arc-shaped plate 165 is also connected to outer edges of two semi-circular plates 164. The exhaust port is defined on the arc-shaped plate 165. The arc-shaped plate 165 and the two semi-circular plates 164 enclose to form an exhaust chamber with a gradually decreasing inner diameter (not shown in the figures). Specifically, during the gas reacted in the reaction chamber 111 being discharged, the arc-shaped plate 165 and the two semi-circular plates 164 can play a certain guiding role in the gas discharge. The gas discharged from the reaction chamber 111 to the exhaust assembly 16 can converge from the periphery to the center and be discharged along the exhaust tube 163. This prevents the longer distance between the periphery gas and the exhaust tube 163 from negatively affecting its discharge efficiency. On one hand, the efficiency of the entire exhaust process can be significantly improved to save exhaust time. On the other hand, the exhaust chamber can achieve exhaust without dead ends in both horizontal and vertical directions, covering any corner of the reaction chamber 111. This can also solve the problem of uneven distribution of exhaust speed on the reactant.

In some embodiments, the exhaust assembly 16 may also have other structures with an inner diameter that gradually decreases in a direction away from the second end 113. As the inner diameter gradually decreases, an inner wall of the exhaust assembly 16 is inclined, which can play a certain role in guiding the gas in the exhaust assembly 16, thereby facilitating the exhaust without dead ends in both horizontal and vertical directions in the exhaust chamber.

As illustrated in FIG. 2, in some embodiments, the reaction device 10 further includes a temperature sensor 17, and the temperature sensor 17 is disposed on a top of the reaction housing 11 and configured to measure a temperature inside the reaction chamber 111, so as to better assist in controlling the temperature inside the reaction chamber 111. In some embodiments, in a case where the temperature inside the reaction chamber 111 is insufficient, a specific temperature value in the reaction chamber 111 can be directly understood by using the temperature sensor 17, and appropriate adjustments can be made, so as to ensure that the temperature inside the reaction chamber 111 is an optimal temperature for the reaction source to experience the reaction. In some embodiments, in a case where the temperature inside the reaction chamber 111 is too high, the temperature inside the reaction chamber 111 can likewise be appropriately adjusted based on the temperature value transmitted by the temperature sensor 17, so that the temperature inside the reaction chamber 111 is the optimal temperature. In this case, since the temperature inside the reaction chamber 111 is the optimal temperature for the reaction source to experience the reaction, the thickness uniformity of the film on the reactant in the reaction chamber 111 can also be improved.

In some embodiments of the present disclosure, the reaction device 10 further includes a support base 18. The support base 18 may be capable of moving up and down, and the support base 18 is disposed on and covers a bottom of the reaction housing 11. The support base 18 is configured to support the reactant. Disposing the support base 18 can enable the reactant to be placed more stably in the reaction chamber 111, reducing the gas flow resistance in the reaction chamber 111, so that the thickness of the film on the reactant is more uniform. In some embodiments, the support base 18 may be circular. In a case where the support base 18 is circular, there are usually no bends or corners, which can reduce the gas flow resistance, so that the thickness of the film on the reactant is more uniform. In some embodiments, the support base 18 may also adopt a non-circular structure, which is not repeated here.

In some embodiments, the reaction device 10 further includes a gas sub-pipe 19 and an annular groove 191. The gas sub-pipe 19 is disposed on a side wall of the flow equalizing plate 14 and configured for introducing an inert gas. The annular groove 191 is defined on the periphery of the first end 112 of the reaction housing 11. The annular groove 191 is communicated with the gas sub-pipe 19 to form a gas seal. The flow equalizing plate 14 is in contact with the first end 112 of the reaction housing 11, there may be some small gaps between the flow equalizing plate 14 and the first end 112 of the reaction housing 11. During the reactant flowing into the reaction chamber 111 through the intake port 121, the gas sub-pipe 19 is defined and configured for introduce the inert gas. After the gas sub-pipe 19 is communicated with the annular groove 191, the inert gas forms the gas seal in the annular groove 191, which can effectively prevent the reaction source from flowing out from the gaps. This can ensure the concentration of the reaction source, and reduce the gas flow resistance in the reaction chamber 111, thereby improving the thickness uniformity of the film on the reactant.

In some embodiments, the reaction device further includes fixing studs 110, the fixing studs are disposed on both sides of the reaction housing 11, respectively. A height of each fixing stud 110 is not less than half of a height of the reaction housing 11. Disposing the fixing studs 110 can provide a certain fixing effect on the reaction housing 11, so that the entire structure is more stable during the reaction of the reaction source in the reaction chamber 111.

In some embodiments of the present disclosure, a semiconductor coating device is further provided. The semiconductor coating device includes the above reaction device 10.

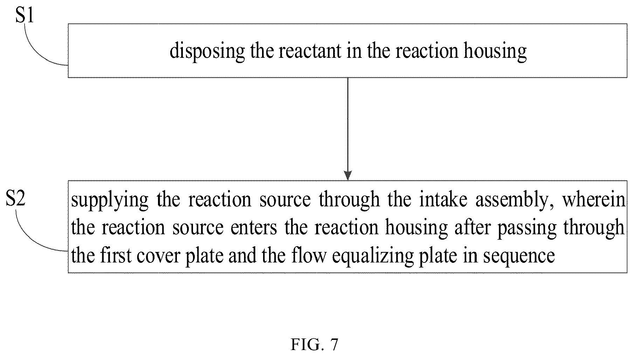

As illustrated in FIG. 7, FIG. 7 is a flowchart of an embodiment of a coating method of the present disclosure. A coating method is provided in some embodiments of the present disclosure. The coating method adopts the reaction device 10 or the semiconductor coating device in the above embodiments. The coating method includes the following operations. At block S1, the coating method may include disposing the reactant in the reaction housing 11. At block S2, the coating method may include supplying the reaction source through the intake assembly 13, wherein the reaction source enters the reaction housing 11 after passing through the first cover plate 12 and the flow equalizing plate 14 in sequence.

During the entire coating process, the reaction source can diffuse uniformly into the reaction housing 11, so that the concentration distribution of the reaction source in the reaction housing 11 is more uniform, thereby ensuring the thickness uniformity of the film of the reactant.

The above descriptions are only some embodiments of the present disclosure, and are not intended to limit the protection scope of the present disclosure. Any equivalent structure or equivalent flow transformation made by using the contents and the accompanying drawings of the present disclosure, or directly or indirectly applied to other related technical fields, is included in the protection scope of the present disclosure.

## Claims

1. A reaction device, **characterized by** comprising:
a reaction housing, defining a reaction chamber, wherein the reaction chamber is configured to accommodate a reactant, and the reaction housing comprises a first end and a second end opposite to each other;
a first cover plate, disposed on the first end;
an intake assembly, disposed on the first cover plate and communicated with the reaction chamber; and
a flow equalizing plate, disposed between the first cover plate and the reaction housing;
wherein an arrangement direction of the first cover plate and the flow equalizing plate is perpendicular to a vertical axis of the reactant, a wall surface of the flow equalizing plate facing the first cover plate is configured as a protrusion, and a wall surface of the first cover plate facing the flow equalizing plate is configured as a recess.

2. The reaction device according to claim 1, wherein the wall surface of the flow equalizing plate facing the first cover plate is an arc-shaped surface; and in a first direction, a distance between the flow equalizing plate and the first cover plate gradually increases from a middle to both ends.

3. The reaction device according to claim 2, wherein the wall surface of the first cover plate facing the flow equalizing plate is the arc-shaped surface; in a second direction, the distance between the first cover plate and the flow equalizing plate gradually decreases from the middle to the both ends; and the second direction intersects with the first direction.

4. The reaction device according to claim 2 or 3, wherein a central angle of the arc-shaped surface is greater than 0 degrees and less than or equal to 15 degrees.

5. The reaction device according to claim 1, wherein at least two intake ports that are spaced apart from each other are defined on the first cover plate, and the intake assembly comprises:
at least two intake end covers, wherein each intake end cover is disposed to cover a corresponding intake port; and
at least two sets of intake pipes, wherein each set of intake pipes comprises a connection pipe and a ventilation pipe, the connection pipe is communicated with each intake end cover, and the ventilation pipe is communicated with the connection pipe.

6. The reaction device according to claim 5, wherein two intake ports are defined on the first cover plate, and the two intake ports are spaced apart from each other; two intake end covers are disposed, two sets of intake pipes are disposed, and each set of intake pipes comprises one connection pipe and one ventilation pipe; and the connection pipe is communicated with the two intake end covers, and the ventilation pipe is communicated with a middle of the connection pipe.

7. The reaction device according to claim 5, wherein in a spacing direction of two intake ports, one of the two intake ports is defined at a one-third point of the first cover plate, and the other of the two intake ports is defined at a two-third point of the first cover plate.

8. The reaction device according to claim 5, wherein the intake assembly further comprises a flow guide block, the flow guide block is disposed on a side of each intake end cover facing the corresponding intake port, and connection ends of the connection pipe that are communicated with each intake end cover are disposed around periphery of the flow guide block at intervals.

9. The reaction device according to claim 8, wherein the reaction device further comprises a partition plate, the partition plate is disposed between the flow equalizing plate and the first cover plate, and a plurality of intake holes are defined in an array on the partition plate.

10. The reaction device according to claim 9, wherein the partition plate is provided with a partition sub-plate corresponding to each intake port, and a plurality of flow guide holes are defined in an array on the partition sub-plate.

11. The reaction device according to claim 1, wherein the reaction device further comprises an exhaust assembly, the exhaust assembly is disposed on the reaction housing, and the exhaust assembly comprises:
a second cover plate, disposed on the second end of the reaction housing and defining an exhaust port; and
an exhaust tube, disposed on the second cover plate and communicated with the exhaust port.

12. The reaction device according to claim 11, wherein the second end of the reaction housing comprises a first side and a second side opposite to each other, as well as a third side and a fourth side opposite to each other; and the second cover plate comprises:
two semi-circular plates, wherein each of the first side and the second side is provided with one semi-circular plate, and the two semi-circular plates are inclined towards each other; and
an arc-shaped plate, wherein the arc-shaped plate is connected to the third side, the fourth side, and outer edges of the two semi-circular plates; and the exhaust port is defined on the arc-shaped plate, and the arc-shaped plate and the two semi-circular plates enclose to form an exhaust chamber with a gradually decreasing inner diameter.

13. The reaction device according to claim 1, wherein the reaction device further comprises a temperature sensor, and the temperature sensor is disposed on a top of the reaction housing and configured to measure a temperature inside the reaction chamber.

14. The reaction device according to claim 1, wherein the reaction device further comprises:
a gas sub-pipe, disposed on a side wall of the flow equalizing plate and configured for introducing an inert gas; and
an annular groove, defined on periphery of the first end of the reaction housing and communicated with the gas sub-pipe to form a gas seal.

15. The reaction device according to claim 1, wherein the reaction device further comprises fixing studs, each of two opposite sides of the reaction housing is provided with one fixing stud, and a height of each fixing stud is greater than or equal to half of a height of the reaction housing.

16. A semiconductor coating device, **characterized by** comprising:
the reaction device according to any one of claims 1 to 15.

17. A coating method, **characterized in that** the coating method adopts the reaction device according to any one of claims 1 to 15 or the semiconductor coating device according to claim 16, and the coating method comprises:
disposing the reactant in the reaction housing; and
supplying a reaction source through the intake assembly, wherein the reaction source enters the reaction housing after passing through the first cover plate and the flow equalizing plate in sequence.
